# EUROPÄISCHE PATENTSCHRIFT

(11) **EP 3 087 213 B1**
(45) Veröffentlichungstag und Bekanntmachung des Hinweises auf die Patenterteilung: **14.03.2018**
(21) Anmeldenummer: 15821030.2
(22) Anmeldetag: 11.12.2015
(51) Int. Cl.: C23C 14/56, C23C 16/54, B65G 35/06

(54) **DURCHLAUFANLAGE**
CONTINUOUS SYSTEM
SYSTÈME DE PASSAGE

(30) Priorität: 22.12.2014 DE 102014226780; 12.10.2015 DE 102015219668
(43) Veröffentlichungstag der Anmeldung: 02.11.2016
(73) Patentinhaber: Singulus Technologies AG, 63796 Kahl am Main (DE)
(72) Erfinder: KEMPF, Stefan, 63755 Alzenau (DE); SCHRAMM, Holger, Dietzenbach 63128 (DE)
(74) Vertreter: Vossius & Partner Patentanwälte Rechtsanwälte mbB
(86) Internationale Anmeldenummer: PCT/EP2015/079416
(87) Internationale Veröffentlichungsnummer: WO 2016/102212

(56) Entgegenhaltungen:
- US-A- 6 139 695
- US-A1- 2012 031 735

## Beschreibung

Die vorliegende Erfindung bezieht sich allgemein auf das Gebiet der Durchlaufanlagen, insbesondere getakteter und kontinuierlicher Durchlaufanlagen mit mindestens einer im Vakuum betriebenen Bearbeitungskammer, wie z.B. in Beschichtungsanlagen zur Beschichtung von Halbleiterwafern, Kunststoffteilen bzw. Formteilen aus Kunststoff, Glas, Metall, oder Keramik usw.

In kommerziellen Vakuumanlagen, insbesondere getakteten Vakuumanlagen zur Beschichtung von Bauteilen, z.B. Kunststoffteile, soll ein hoher Durchsatz und sehr kleine Transportzeiten, d.h. geringe Totzeiten, erzielt werden, da während der Transportzeit der Beschichtungsprozess unterbrochen werden muss. Bei einer getakteten Einzelsubstratmaschine mit sehr kurzen Zykluszeiten/Prozesszeiten sinkt die Produktivität aufgrund des steigenden Anteils der Transportzeit an der Zykluszeit (Transport + Prozess). Eine wirtschaftliche und technische Realisierung ist nicht sinnvoll. Folglich müssen mehrere Substrate gleichzeitig ins Vakuum gebracht werden, was zu Zykluszeitproblemen beim Beladen und Vereinzeln der Substrate in der Schleuse führt. Aus diesem Grund werden Trägersysteme/Carrier bei Produktionsanlagen mit hohem Durchsatz verwendet, die mehrere Substrate gleichzeitig beschichten. Diese Trägersysteme werden außerhalb der Schleuse bestückt und als eine Einheit / "quasi Einzelsubstrat" in die Schleuse überführt.

Bekannte Systeme, wie z.B. in den Dokumenten DE 198 06 282 C1, US 6,656,330 B2 und WO 2013/045110 A1 beschrieben, sind meist als Rundtaktmaschinen, ähnlich der in der Optical Disc Industrie verwendeten Metallisierer aufgebaut. Diese besitzen meist eine Schleuse für das Ein- und Ausschleusen der Substrate, wobei meist der Verschlussmechanismus der Schleuse mit dem Substrathaltemechanismus gekoppelt ist. Üblicherweise besitzen diese Maschinen ein zweiarmiges Handling mit zwei Verschlussmechanismen, welche abwechselnd die Schleuse verschließen bzw. sich in der Austauschposition für die Substrate befinden. Diese Systeme können in der Schleusenstation kurze Zykluszeiten erzielen.

Bekannte System sind auch sogenannte Durchlaufanlagen (In-Line Anlagen), wie sie z.B. für Glasbeschichtungen eingesetzt werden. Die Bewegung (Beschleunigungs- und Verzögerungskräfte) der zu beschichtenden Substrate wird hierbei durch rotierende Antriebsrollen erreicht, wobei entweder das Substrat selbst oder ein Träger (Carrier) für die Substrate, durch Schwerkraft auf diesen Rollen aufliegen, und die Antriebskraft durch Reibung übertragen wird. Dadurch sind die erzielbaren Beschleunigungen gering und die Transportzeiten relativ hoch. Durchlaufanlagen sind z.B. aus den Dokumenten DE 10 2007 054 091 A1, US 6 139 695 A und EP 2 053 649 A2 bekannt. US 2012/031735 A1 offenbart eine Kurvenwalze zum Transport von Trägersystemen. Herkömmliche Systeme bedienen sich zusätzlich einer indirekten Positionskontrolle über Sensoren. Hier wird üblicherweise ein erster Sensor verwendet, nach dessen Überfahren die Geschwindigkeit heruntergefahren wird, und mit einer verbleibenden niedrigen Schleichganggeschwindigkeit ein zweiter Sensor zum Anhalten angefahren wird. Dies ist sehr zeitaufwändig und es kommt vor, dass das Positionierfenster überfahren wird. Dann muss mit einer sehr niedrigen Geschwindigkeit im Vorwärts- Rückwärtsbetrieb das Positionierfenster gesucht werden. Dieses Verfahren kostet wieder viel Zeit.

Üblicherweise werden die Carrier auf Rollenstummeln geführt und angetrieben. Dadurch bleibt nahezu die gesamte Fläche des Carriers für die Beschichtung (auch von unten) frei. Außerdem ist der Kontakt zwischen Carrier und Rollenstummel minimiert, so dass bei aufgeheizten Carriern (manchmal sind Temperaturen von 400°C gefordert) wenig Energie abfließt. Die Carrier können jedoch bei einem ungünstigen Längen/Breiten-Verhältnis auf den Rollenstummeln verkannten (Schubladeneffekt), weshalb die Carrier üblicherweise mit der kurzen Seite voran durch die Anlage gefahren werden.

Bei den herkömmlichen Systemen kann bei engen Toleranzen von Carrierbreite, Rollenstummelabständen und geringen thermischen Ausdehnungen auch mit der langen Seite voran durch die Anlage gefahren werden, jedoch nur bis zu einem Längen/Breiten-Verhältnis von 0,66 : 1. Ab einem Längen/Breiten-Verhältnis (L-B-Verhältnis) von ca. 0,5:1 kann das Trägersystem evtl. in der Transportebene verkanten und somit nicht weiter transportiert werden.

Mit abnehmender Länge besteht die Möglichkeit, dass ein Substrat aus der Transportebene kippt. Um dies zu verhindern sind immer mindestens zwei Rollen zur Substratabstützung erforderlich. Das Teilungsmaß der Rollenabstände müsste also < 0,5*L sein. Dies hätte sehr viele Rollen und kleine Rollenabstände zur Folge, da L< 0,5*B ist. Alle Rollen müssten angetrieben werden. Meist wird für jede Rolle die Drehbewegung von der Atmosphärenseite über eine Drehdurchführung ins Vakuum geleitet.

Die bekannten Anlagen können nach der Orientierung der Substrate unterschieden werden: Horizontal und vertikale Anlagen. Beide Anlagentypen gibt es mit und ohne Carrier. Bei den horizontalen Anlagen kann man weiterhin Anlagen mit durchgängigen Rollen und solche mit kurzen Rollenstummeln an beiden Seiten der Prozesskammer unterscheiden. Letztgenannte werden meist in Verbindung mit Carriern eingesetzt. Um den Carrier führen zu können, werden die Rollenstummeln häufig mit einer angeschrägten Schulter versehen (ähnlich einem Eisenbahnrad). Der Abstand der Schultern zueinander muss größer sein als die Breite des Carriers um ein Verklemmen zu vermeiden. Dieses Spiel erlaubt jedoch eine gewisse Schrägstellung des Carriers, welche beim Auflaufen auf die angeschrägte Schulter des Rollenstummels immer wieder ruckartig korrigiert wird. Wenn eine Anlage bei verschiedenen Temperaturen betrieben wird, muss die thermische Ausdehnung bei der Auslegung des Spiels berücksichtigt werden.

Alternativ können die Rollenstummel profiliert sein. Dieses Profil übernimmt dann im Zusammenspiel mit einer Profilschiene am Carrier die Führungsaufgabe. Die andere Rollenseite bleibt unprofiliert und kann die thermischen Ausdehnungen aufnehmen.

Vertikale Anlagen können nochmals danach unterschieden werden, ob das Substrat senkrecht oder geneigt (meist mit ca. 7°) durch die Anlage transportiert wird. Bei diesen Anlagentypen stehen die Substrate oder Carrier meist mit dem Eigengewicht auf den unteren Rollen, welche den Antrieb übernehmen. Diese Rollen sind profiliert und gewährleisten im Zusammenspiel mit einer Profilschiene die Führung. An der Oberseite des Carriers ist meist eine Vorrichtung angebracht die die vertikale Ausrichtung des Carriers sicherstellen. Bei schräg gestellten Substraten und Carriern kann diese Funktion auch durch Stützrollen übernommen werden. Alle bisher aufgezählten Varianten übertragen die Antriebskraft auf das Substrat bzw. Carrier durch Reibung und sind daher nicht schlupffrei.

Vertikale Anlagen wurden vereinzelt auch mit oben liegendem Antriebssystem gebaut. Auch ein magnetisches Antriebs und Führungssystem (ähnlich Transrapid) wurde bereits realisiert.

Die der vorliegenden Erfindung zu Grunde liegende Aufgabe besteht darin, eine Vorrichtung bereitzustellen, um kurze Taktzeiten und einen hohen Durchsatz in einer getakteten oder kontinuierlichen Durchlaufanlage zu erreichen. Ferner ist es eine Aufgabe der Erfindung eine genaue und zuverlässige Positionierung in solchen Anlagen zu erreichen. Somit soll eine effiziente und kostengünstige Beschichtung von Bauteilen in einer Durchlaufanlage erreicht werden. Ferner soll das oben beschriebene Verhältnis von Carrierlänge zur Carrierbreite von 0,6 : 1 erweitert werden und der Nachteil der engen Toleranzen und der Temperaturbegrenzung aufgehoben werden. Dadurch soll eine Verkürzung der Anlage erreicht werden um so einen hohen Durchsatz zu erreichen. Der vorliegenden Erfindung liegt ferner die Aufgabe zugrunde eine präzise Führung und eine formschlüssige Kraftübertragung bereitzustellen.

Diese Aufgaben werden mit den Merkmalen der unabhängigen Patentansprüche gelöst. Die abhängigen Patentansprüche beziehen sich auf weitere Aspekte der Erfindung.

Die vorliegende Erfindung stellt eine Durchlaufanlage zur formschlüssigen Übertragung von Beschleunigungs- und Verzögerungskräften bereit. Die Durchlaufanlage besteht aus mindestens einem Trägersystem mit mindestens zwei Verbindungselementen und mehreren in Transportrichtung in einer Transportebene hintereinander angeordneten Transportsystemen. Die Transportsysteme weisen jeweils eine zur Transportrichtung achsparallele Kurvenwalze auf, wobei die Kurvenwalzen einen mittleren Bereich aufweisen, der einen ersten Durchmesser d₁ aufweist und mindestens einen zweiten Durchmesser d₂ an den Enden der Kurvenwalzen, wobei d₂ < d₁. Der Abstand zwischen zwei aufeinander folgende mittlere Bereiche der Kurvenwalzen ist kleiner als der Abstand zwischen den mindestens zwei Verbindungselementen eines Trägersystems. Die Kurvenwalzen weisen in dem mittleren Bereich eine schraubenförmige Nut oder einem schraubenförmigen Kurvensteg auf, und die Verbindungselemente des Trägersystems greifen formschlüssig in die Nut der Kurvenwalze ein bzw. umgreifen den Kurvensteg. Die Transportsysteme weisen mindestens eine Bearbeitungskammer mit mindestens zwei Vakuumschleusen für einen Vakuumbetrieb der Bearbeitungskammer auf, wobei die Bearbeitungskammer eine Kammerinnenwand und eine Vertiefung aufweist, in der die Kurvenwalze angeordnet ist, wobei ein Abstand a der Kurvenwalzenachse zur Kammerinnenwand im Bereich d₂/2 < a < d₁/2 liegt. Die Durchlaufanlage weist ferner mindestens eine Antriebseinheit (z.B. ein Motor oder eine Königswelle) zum Antrieb der Kurvenwalzen auf. Die oben genannte Bedingung für den Abstand a der Kurvenwalzenachse zur Kammerinnenwand der Bearbeitungskammer gilt entsprechend für mögliche weitere Kammern der Durchlaufanlage.

Die Kurvenwalzen sind vorzugsweise koaxial angeordnet, d.h. es ist bevorzugt, dass die Kurvenwalzenachsen entlang einer Geraden angeordnet sind.

Gemäß einer Ausführungsform der vorliegenden Erfindung kann das Verbindungselement mehrere drehbar gelagerte Laufrollen aufweisen.

Gemäß einer alternativen Ausführungsform der vorliegenden Erfindung kann das Verbindungselement ein oder mehrere stiftförmige Elemente aufweisen.

Die Transportsysteme können dabei eine Be- und Entladekammer und/oder eine Ein- und Ausschleusekammer und/oder mindestens eine Bearbeitungskammer aufweisen.

Dabei können die Ein- und Ausschleusekammer und/oder die mindestens eine Bearbeitungskammer zusätzlich Vakuumschleusen aufweisen und geeignet sein unter Vakuum betrieben zu werden.

Erfindungsgemäß kann jedes der mehreren Transportsysteme einen eigenen Motor (Antriebseinheit) aufweisen. Ferner können sich zwei oder mehrere Transportsysteme einen Motor teilen und andere Transportsysteme jeweils einen eigenen Motor aufweisen. Mit anderen Worten, die Transportsysteme können einen Motor aufweisen, der alle Transportsysteme antreibt oder die Transportsysteme weisen mindestens zwei Motoren auf, die jeweils mindestens ein Transportsystem antreiben.

Erfindungsgemäß können die Motoren jeweils einen Encoder aufweisen, wobei der Encoder zur Positionsbestimmung der Trägersysteme geeignet ist. Die Winkelstellung des Encoders steht in direkter Relation zur Winkelstellung der Kurventrommel, so dass in Verbindung mit einem Schieberegister die Trägerposition exakt bestimmt werden kann.

Das mindestens eine Trägersystem kann in der Transportrichtung in der Transportebene länger als senkrecht zu der Transportrichtung in der Transportebene und länger als senkrecht zu der Transportebene sein. Mit anderen Worten, das Trägersystem kann länger sein als breit und hoch, wobei sich die Länge auf die Ausdehnung entlang der Transportrichtung (z-Richtung) bezieht und die Breite auf eine Ausdehnung senkrecht zur Transportrichtung in der Ebene, die durch die Transportrichtung und der Verbindung (x-Richtung) des Mittelpunktes der Kurvenwalze mit dem Eingriffspunkt des Verbindungselementes in die Kurvenwalze definiert ist.

Alternativ kann das mindestens eine Trägersystem in der Transportrichtung in der Transportebene kürzer als senkrecht zu der Transportrichtung in der Transportebene und/oder kürzer als senkrecht zu der Transportebene sein, vorzugsweise im Verhältnis 0,3-0,5:1. Mit anderen Worten, das Trägersystem kann auch kürzer als breit und/oder hoch sein. Die Höhe ist durch die Normale auf der Transportebene definiert. Wenn ein Trägersystem (Carrier) z.B. 100 mm kürzer ist, so würde eine Anlage mit 4 Kammern um jeweils 100 mm kürzer, d.h. insgesamt um 400 mm kürzer. Die Anlage müsste nicht breiter werden, da die kontinuierliche Transportgeschwindigkeit im Bereich der Prozessstrecke gleich bleibt.

Ferner kann die erfindungsgemäße Vorrichtung ein reibungsbehaftetes Führungssystem aufweisen, das vorzugsweise ein erstes Führungselement und ein zweites Führungselement aufweist, wobei das erste Führungselement auf der Seite des Trägersystems mit dem Verbindungselement angeordnet ist und das zweite Führungselement auf der gegenüberliegenden Seite des Trägersystems angeordnet ist.

Die Transportsysteme können mindestens eine Bearbeitungskammer mit mindestens einer ersten Pufferkammern, mindestens eine Prozesskammer im Anschluss an die mindestens eine erste Pufferkammer und mindestens eine zweite Pufferkammer im Anschluss an die mindestens eine Prozesskammer aufweisen.

Die Durchlaufanlage kann ferner eine Einrichtung zur individuellen Ansteuerung der mehreren Transportsysteme zum kontinuierlichen Lauf der Trägersysteme in einer Bearbeitungskammer aufweisen und/oder zum Einstellen eines vorgegebenen Abstands zwischen den hintereinander angeordneten Trägersystemen.

Vorzugsweise ist mindestens ein Ende (oder auch beide Enden) der Kurvenwalzen mit dem Durchmesser d₂ durch mindestens eine Wand der Vertiefung nach außen geführt wird, um dort durch die Antriebseinheit angetrieben zu werden. Mit anderen Worten, das Ende/die Enden der Kurvenwalzen sind bevorzugt durch die Wandung (Wand senkrecht zur Transportrichtung) der Vertiefung an Atmosphäre gebracht, um die Kurvenwellen dort unter Verwendung der Antriebseinheit anzutreiben.

Die Tiefe der Nut ist bevorzugt größer als die Länge der Verbindungselemente in Tiefenrichtung der Nut, vorzugsweise in Radialrichtung der Kurvenwalze. Die maximale Eintauchtiefe der Verbindungselemente d muss im Bereich 0 < d < = 0,5*d₁ liegen. Die Eintauchtiefe der Verbindungselemente in die Nut und somit der Abstand der Verbindungselemente von der Kammerinnenwand, wird bevorzugt durch das Führungssystem eingestellt.

Der Abstand a der Kurvenwalzenachse zur Kammerinnenwand ist vorzugsweise durch die Summe aus einer Kammerwanddicke w, des Radius des Antriebsritzels/Funktionselements r/2 und eines Spalts des Funktionselements zur Kammerwand s definiert.

Nachfolgend wird die vorliegende Erfindung anhand von bevorzugten Ausführungsbeispielen und den Figuren näher erläutert.
Fig. 1 zeigt schematisch den Aufbau einer beispielhaften Ausführungsform der erfindungsgemäßen Lösung;
Fig. 2 zeigt einen Ablaufplan der beispielhaften Ausführungsform gemäß Fig. 1;
Fig. 3 zeigt schematisch den Aufbau einer weiteren beispielhaften Ausführungsform der erfindungsgemäßen Lösung;
Fig. 4 zeigt einen Ablaufplan der beispielhaften Ausführungsform gemäß Fig. 3;
Fig. 5 zeigt schematisch den Aufbau einer weiteren beispielhaften Ausführungsform der erfindungsgemäßen Lösung;
Fig. 6 zeigt einen Ablaufplan der beispielhaften Ausführungsform gemäß Fig. 5;
Fig. 7 zeigt den prinzipiellen Aufbau der erfindungsgemäßen formschlüssigen Antriebsvorrichtung;
Fig. 7a zeigt einen Ausschnitt eines schematischen Aufbaus einer Vakuumanlage gemäß einer beispielhaften Ausführungsform der vorliegenden Erfindung;
Fig. 8 zeigt schematisch den Aufbau einer weiteren beispielhaften Ausführungsform der erfindungsgemäßen Lösung;
Fig. 9 zeigt einen schematischen groben Ablaufplan der beispielhaften Ausführungsform gemäß Fig. 8 der erfindungsgemäßen Lösung;
Fig. 10 zeigt einen schematischen zweiten Ablaufplan der beispielhaften Ausführungsform gemäß Fig. 8 der erfindungsgemäßen Lösung;
Fig. 11 zeigt ein Ablaufschema der beispielhaften Ausführungsform gemäß Fig. 8 der erfindungsgemäßen Lösung; und
Fig. 12 zeigt einen prinzipiellen alternativen Aufbau der erfindungsgemäßen formschlüssigen Antriebsvorrichtung.

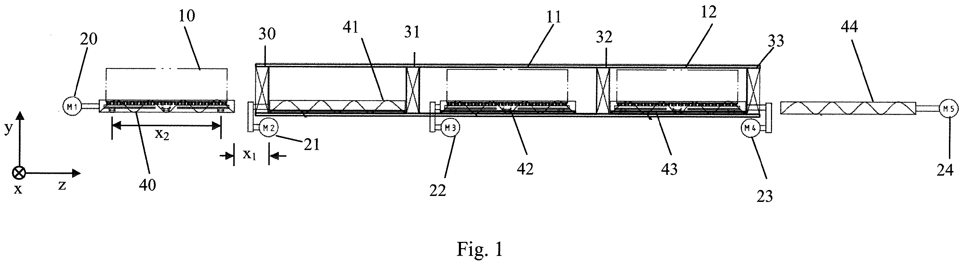

Eine bevorzugte Ausführungsform der Erfindung ist schematisch in Fig. 1 dargestellt. In Fig. 1 sind insgesamt drei Trägersysteme 10, 11, 12, vier Vakuumschleusen 30, 31, 32, 33 und fünf Kurvenwalzen 40, 41, 42, 43, 44 mit Motoren 20, 21, 22, 23, 24 gezeigt.

Das in Fig. 1 gezeigte Koordinatensystem legt die Richtungen bzw. die Ebenen des Systems fest und wird im Folgenden für die weiteren Figuren einheitlich verwendet. Die Transportrichtung ist entlang der z-Achse definiert. Senkrecht zur Transportrichtung liegt die x-Achse, wobei die x-Achse und die z-Achse in einer Ebene (Transportebene) liegen bzw. diese Ebene definieren. Die y-Achse steht senkrecht (Normalenrichtung) auf der durch die x-Achse und y-Achse definierten Ebene.

Gemäß Fig. 1 besteht das System aus fünf durch Vakuumschleusen 30-33 getrennten Kurvenwalzen 40-44. Der Bereich der Kurvenwalzen 41, 42, 43 entlang der z-Achse (die im dargestellten Beispiel in horizontaler Richtung liegt) definiert, zusammen mit den abgrenzenden Vakuumschleusen 30-33, jeweils eine Prozesskammer. Die erste Kurvenwalze 40 und die hintere Kurvenwalze 44 schließen sich hier dem Anlagentransportsystem (nicht gezeigt) an und können als Be- und Entladestationen bezeichnet werden. In dieser beispielhaften Ausführungsform befinden sich diese beiden Kurvenwalzen 40, 44 nicht im Vakuum. Auf die Beladestation folgen drei Vakuumkammern (Prozesskammern). Die mittlere dieser drei Kammern ist die Beschichtungskammer (Bearbeitungskammer), in der die Beschichtung der Bauteile stattfindet. Die Kammer mit Kurvenwalze 41 ist eine sogenannte Einschleusekammer und die Kammer mit der Kurvenwalze 43 ist eine sogenannte Ausschleusekammer. Auf der Rückförderstrecke (nicht gezeigt) können die Substrate taktunabhängig ausgetauscht bzw. getrennt be- und entladen werden. Hierdurch steht dem Handlingsystem ein großes Zeitfenster zur Verfügung, so dass eine Vielzahl von Substraten auf den Trägersystemen 10-12 bearbeitet werden können.

Die Kurvenwalzen 40-44 werden jeweils getrennt voneinander von Motoren 20-24 angetrieben. Erfindungsgemäß bildet jede der Kurvenwalzen 40-44 einen Zylinder mit einer schraubenförmigen Nut oder einem schraubenförmigen Kurvensteg. Die Trägersysteme 10, 11, 12 sind z.B. mit drehbar gelagerten Laufrollen ausgestattet, um formschlüssig mit der schraubenförmige Nut oder dem schraubenförmigen Kurvensteg in Eingriff zu kommen. Alternativ zu den drehbar gelagerten Laufrollen sind auch andere Ausgestaltungen denkbar, z.B. ein stiftförmiges Element, solange dieses geeignet ist, in die schraubenförmige Nut einzugreifen oder mit dem schraubenförmigen Kurvenstegzusammenzuwirken, um über Formschluss die Beschleunigungs- und Verzögerungskräfte zu übertragen. Die Kurvenwalzen 40-44 sind jeweils an den Übergängen zur nächsten Prozesskammer unterbrochen. Dadurch ist es notwendig, die Trägersysteme 10-12 mit mehreren versetzten Laufrollen auszustatten, um einen kontinuierlichen Eingriff der Laufrollen mit der Nut bzw. mit dem Kurvensteg der Kurvenwalzen 40-44 zu gewährleisten. Die beschriebenen Unterbrechungen der Kurvenwalzen 40-44 sind optional und die Kurvenwalzen 40-44 können auch durchgängig ausgestaltet sein und mit nur einem Motor betrieben werden. Ferner sollte der Abstand x₁ zwischen zwei aufeinander folgenden Kurvenwalzen kleiner sein als der Abstand (Versatz) x₂ zwischen mindestens zwei Laufrollen oder Stiften, z.B. der hintersten und der vordersten Laufrollen bzw. Stifte, eines Trägersystems. Damit wird sichergestellt, dass der Abstand x₁ durch die Anordnung der Laufrollen oder Stifte überbrückt werden kann.

Die Anordnung und die Anzahl der Prozesskammern mit den Kurvenwalzen 40-44 ist hier nur beispielhaft beschrieben. Es ist durchaus möglich, dass eine Durchlaufanlage mit mehr oder weniger Prozesskammern als hier beschrieben arbeitet. Je nach den spezifischen Prozessanforderungen können die Anforderungen somit an die gesamte Anlage angepasst werden. Ein Beschichtungsprozess oder ein Bearbeitungsprozess könnte z.B. auch ohne Ein- und Ausschleusekammer auskommen. Auch Umschleusekammern zwischen unterschiedlichen Druckniveaus sind möglich. Besonders bevorzugt ist allerdings eine Ausführung mit mehreren aufeinanderfolgenden Beschichtungs- bzw. Bearbeitungskammern, wobei die Anzahl der Einschleuse- und Ausschleusekammern konstant bleibt.

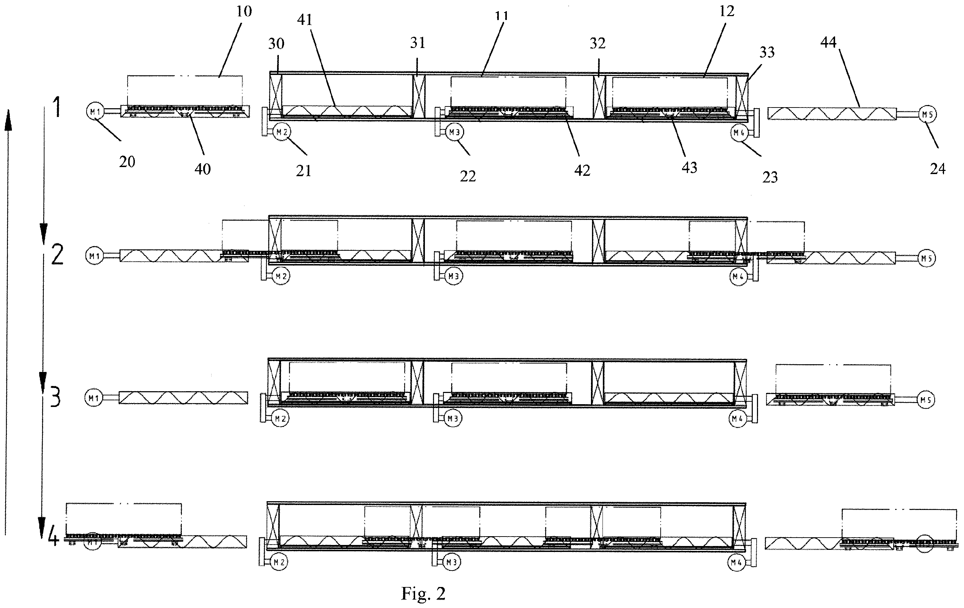

Fig. 2 zeigt einen Ablaufplan, gemäß der Ausführungsform von Fig. 1. In einem ersten Schritt befindet sich ein erstes Trägersystem 10 in der Beladestation mit der Kurvenwalze 40. Ein zweites Trägersystem 11 befindet sich in der Beschichtungskammer mit der Kurvenwalze 42 unter Vakuum, und ein drittes Trägersystem 12 befindet sich in der Ausschleusekammer mit der Kurvenwalze 43. Die Ein- und Ausschleusekammern werden geflutet und die Vakuumschleusen 30 und 33 geöffnet. Das Trägersystem 11 befindet sich in dieser Zeit in der Beschichtungskammer, wo die Bauteile beschichtet werden können. Die Kurvenwalzen 40 und 44 können mit dem Anlagentransportsystem (nicht gezeigt) synchron laufen, um einen kontinuierlichen und zeitsparenden Betrieb der Anlage zu ermöglichen.

In einem zweiten Schritt werden die Kurvenwalzen 40, 41, 43, 44 durch die Motoren 20, 21, 23, 24 angetrieben. Dadurch wird das Trägersysteme 10 in die Einschleusekammer und das Trägersystem 12 aus der Ausschleusekammer bewegt. Die Kurvenwalze 42 wird in diesem Schritt nicht bewegt, damit die Beschichtung der Bauteile weiter durchgeführt werden kann.

In einem dritten Schritt werden die Vakuumschleusen 30 und 33 geschlossen, sobald sich das Trägersystem 10 in der Einschleusekammer bzw. das Trägersystem 12 in der Entladestation befindet. Die Kurvenwalzen 40 und 44 können weiter mit dem Anlagentransportsystem laufen. Das Trägersystem 11 befindet sich weiterhin in der Beschichtungskammer. Die Ein- und Ausschleusekammer werden abgepumpt, um ein Vakuum in diesen Kammern herzustellen. Daraufhin wird der Beschichtungsprozess beendet und die Vakuumschleusen 31 und 32 werden geöffnet.

In einem vierten Schritt wird ein neues Trägersystem vom Anlagentransportsystem an die Beladestation herangeführt und das Trägersystem 12 wird von der Entladestation an das Anlagentransportsystem überführt. Ferner werden die Trägersysteme 10 und 11 durch die Kurvenwalzen 41, 42, 43 in die jeweils anschließenden Kammern gefahren und die Vakuumschleusen 31 und 32 werden geschlossen. Anschließend kann der Prozess bei Schritt 1 von vorne beginnen.

Aufgrund der formschlüssigen Anordnung können die Transportzeiten der Trägersysteme verringert werden, da eine höhere Transportgeschwindigkeit als in herkömmlichen Anlagen gefahren werden kann. Die oben beschriebenen Prozessschritte sind hier nur beispielhaft beschrieben. Eine andere Ansteuerung bzw. Taktung der einzelnen Kurvenwalzen 40-44 kann je nach den spezifischen Prozessanforderungen und Prozessparametern angepasst werden.

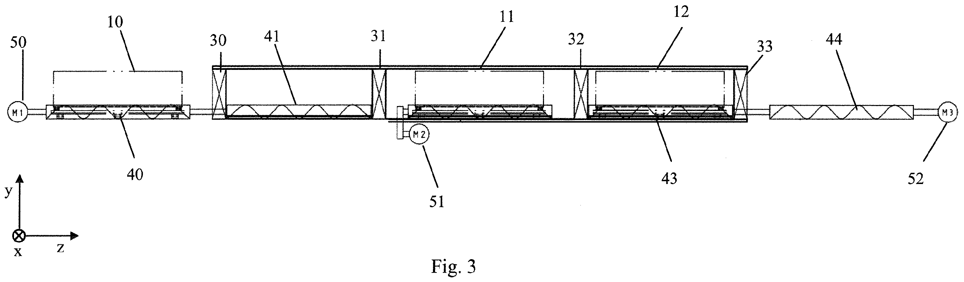

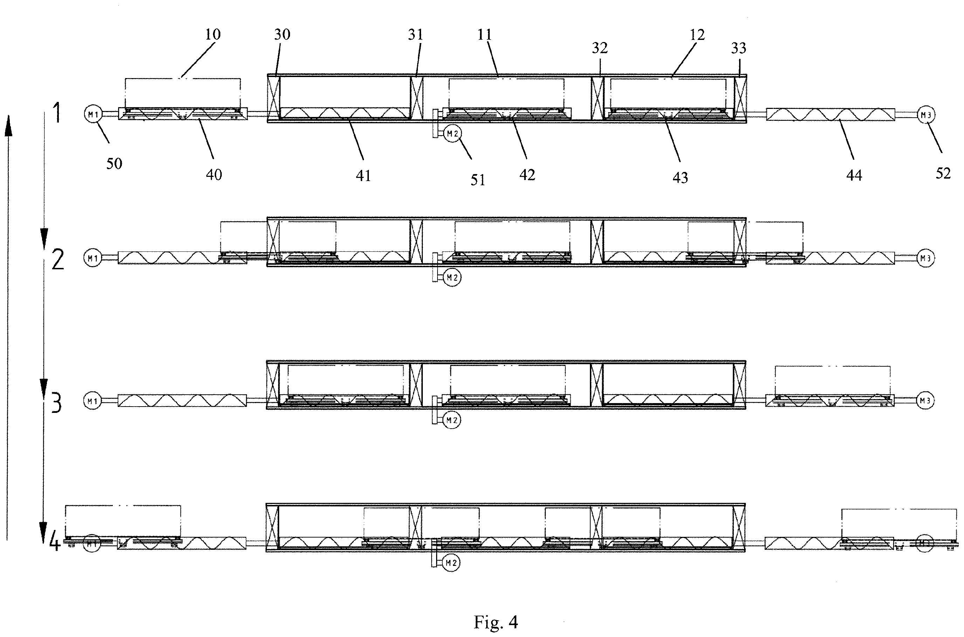

In Fig. 3 wird eine weitere beispielhafte Ausführungsform der vorliegenden Erfindung schematisch dargestellt. Elemente, die schon in Fig. 1 und Fig. 2 beschrieben wurden, sind in Fig. 3 mit den gleichen Referenzzeichen versehen und werden im Folgenden nicht noch einmal beschrieben. Im Gegensatz zu der ersten Ausführungsform in Fig.1 und Fig. 2, sind die Kurvenwalzen 40 und 41, sowie 43 und 44, mechanisch miteinander verbunden. In dieser Ausführungsform werden die Kurvenwalzen 40 und 41 nur mit einem Motor 50 angetrieben. Die Kurvenwalzen 43 und 44 werden mit dem Motor 52 angetrieben und die Kurvenwalze 42 wird mit dem Motor 51 angetrieben. Aus diesem Aufbau ergibt sich der nachfolgend anhand von Fig. 4 beschriebene Ablaufplan.

Fig. 4 beschreibt einen Ablaufplan für die zweite Ausführungsform der vorliegenden Erfindung. Der wesentliche Unterscheid zum Ablaufplan der ersten Ausführungsform aus Fig. 2, wird in Schritt 2 und 4 deutlich. Gemäß Fig. 4 werden im Schritt 2 die Kurvenwalzen 40 und 41, sowie 43 und 44, lediglich durch die zwei Motoren 50 und 52 angetrieben, während die Kurvenwalze 42 mit Motor 51 in Schritt 2 nicht bewegt wird. In Schritt 4 wiederum bewegen sich alle Kurvenwalzen 40-44 jeweils angetrieben durch die drei Motoren 50, 51, 52.

Im Unterschied zum ersten Ablaufplan aus Fig. 2 kann hierbei das neue Trägersystem in Takt 4 nur synchron mit der Bewegung des Trägersystems 10 aus der Einschleusekammer in die Beschichtungskammer bewegt werden. In Fig. 2 könnte dies auch ein eigener Takt sein, da hier die Kurvenwalzen 40 und 41 nicht mechanisch gekoppelt sind.

Die Transportzeiten der Trägersysteme 10-12 werden durch den formschlüssigen Antrieb erfindungsgemäß auch in der zweiten Ausführungsform verringert. Durch die verringerte Anzahl an Motoren können u.a. die Kosten für die Anlage gesenkt werden. Allerdings müssten u.U. Motoren mit höheren Leistungen und höherem Drehmoment verwendet werden.

Die Motoren 20-24 bzw. 50-52 in den oben beschriebenen Ausführungsformen sind vorzugsweise Servomotoren mit entsprechenden Encodern (nicht gezeigt). Hierdurch kann eine genaue und zuverlässige Positionierung der Trägersysteme erreicht werden, wodurch die Prozesszeiten weiter gesenkt werden können.

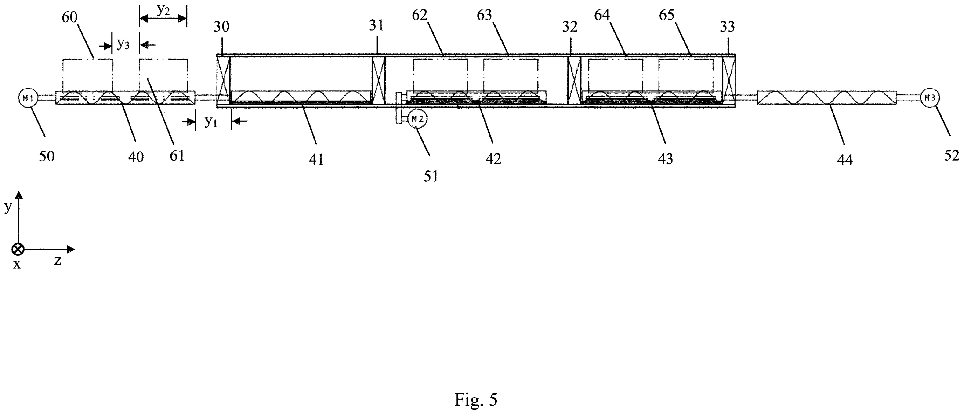

Fig. 5 zeigt eine weitere beispielhafte Ausführungsform der vorliegenden Erfindung. Der wesentliche Unterscheid zu der Ausführungsform aus Fig. 3 ist, dass die Trägersysteme 10-12 in jeweils zwei Trägersysteme 60 und 61, 62 und 63, 64 und 65 aufgeteilt sind. Die jeweils zwei Trägersysteme 60 und 61, 62 und 63, 64 und 65 sind dabei im Wesentlichen definiert hintereinander angeordnet und können jeweils synchron verfahren werden. Wie oben bereits anhand von Fig. 1 beschrieben, sollte der Abstand y₁ zwischen zwei aufeinanderfolgenden Kurvenwalzen, z.B. Kurvenwalzen 40 und 41, durch das jeweilige Trägersystem 60, 61, 62, 63, 64, 65 überbrückbar sein, indem mindestens zwei Laufrollen oder Stifte, z.B. die hinterste und die vorderste Laufrolle bzw. Stift, des jeweiligen Trägersystems (z.B. Trägersystem 61) einen größeren Abstand y₂ als y₁ aufweisen. Ferner sollte der Abstand y₃ zwischen jeweils den zwei direkt hintereinander angeordneten Trägersystemen, z.B. den Trägersystemen 60 und 61, größer als der Abstand y₁ sein. Allerdings erlaubt eine doppelgängige Kurvenwalze auch einen geringeren Abstand von y₃ als der Abstand y₁.

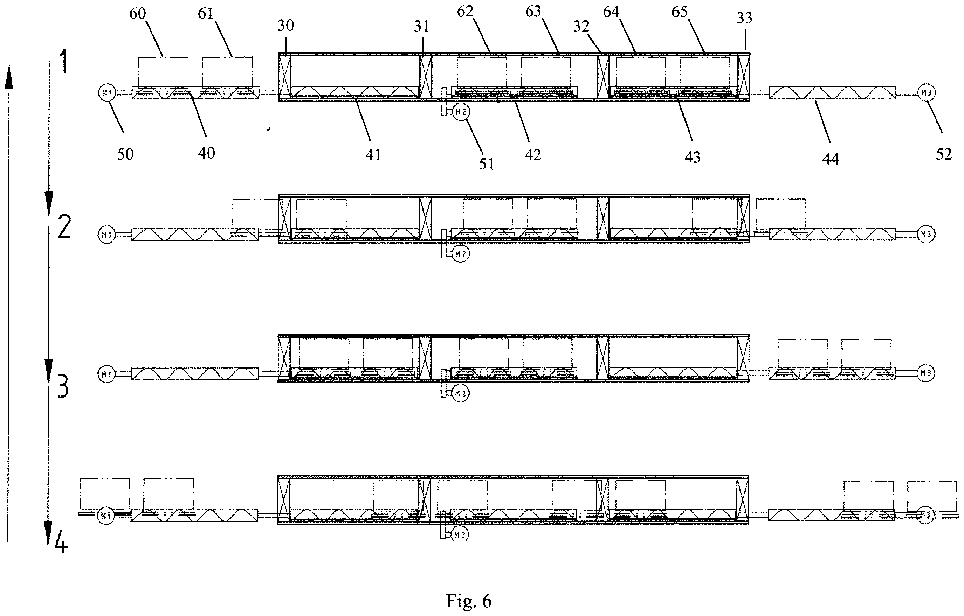

Fig. 6 zeigt den Ablaufplan gemäß der Ausführungsform von Fig. 5 in analoger Weise zu dem Ablaufplan aus Fig. 4. Obwohl die Ausführungsform gemäß den Figuren 5 und 6 analog zu der Ausführungsform der Figuren 3 und 4 mit jeweils drei Motoren 50, 51, 52 dargestellt ist, kann der Fachmann leicht erkennen, dass die Ausführungsform gemäß den Figuren 5 und 6 nicht auf die Anzahl der verwendeten Motoren beschränkt ist. Eine Kombination aus der Ausführungsform gemäß den Figuren 1 und 2, sowie aus den Figuren 5 und 6, ist z.B. leicht zu realisieren.

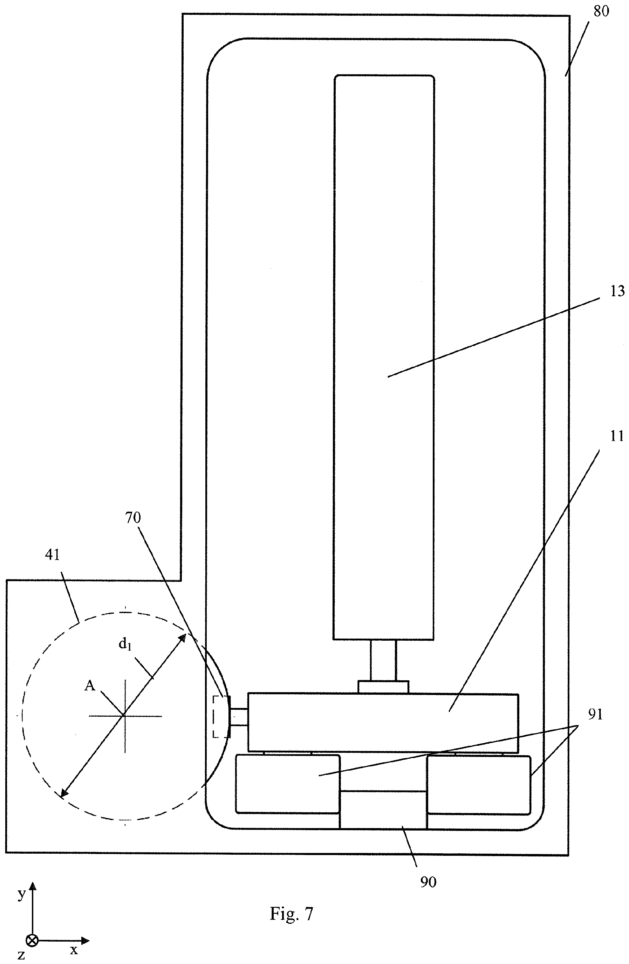

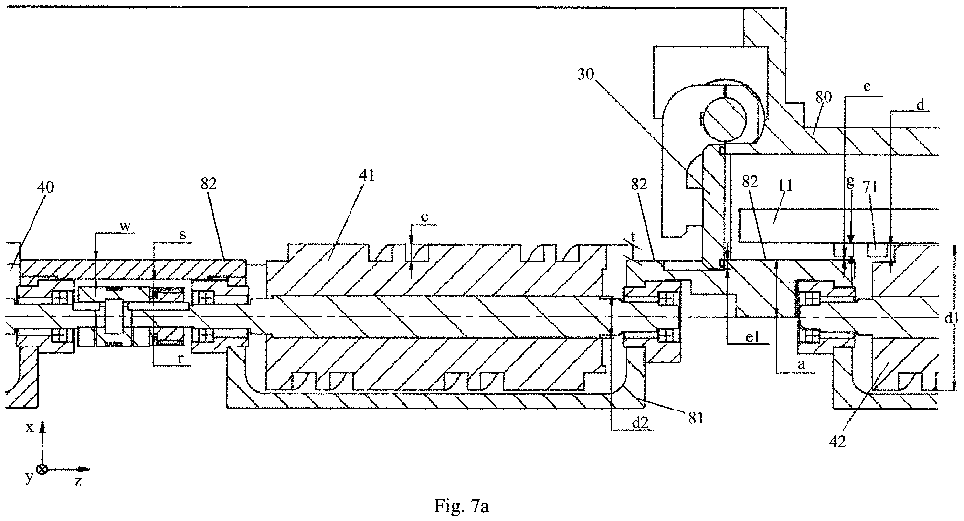

In Fig. 7 wird der erfindungsgemäße formschlüssige Antrieb näher beschrieben. Fig. 7 zeigt beispielhaft eine Kurvenwalze 41, ein Trägersystem 11 (vgl. Fig. 1), ein Substrat 13 sowie ein drehbar gelagertes Verbindungselement 70 (Rolle oder Stift). Die Kurvenwalze 41 ist ein Zylinder mit einer schraubenförmigen Nut oder einem schraubenförmigen Kurvensteg, mit welchen das Verbindungselement 70 (z.B. die Laufrolle) des Trägersystems 11 formschlüssig in Eingriff steht. Dadurch können die Beschleunigungs- und Verzögerungskräfte durch Formschluss übertragen werden. Somit sind die erzielbaren Beschleunigungen hoch und die Transportzeiten relativ niedrig. Die Transportrichtung (entlang der z-Achse) erstreckt sich somit entlang der Hauptachse (Zylinderachse) der zylindrischen Kurvenwalzen 41. Die Transportebene wird durch die Transportrichtung (z-Achse) und dem Radius der Kurvenwalze 41 zum Eingriffspunkt des Verbindungselementes 70 in die Nut oder den Kurvensteg (x-Achse) eindeutig festgelegt. Mit anderen Worten, die Transportebene wird durch die Transportrichtung und der senkrechten Verbindung zwischen Zylinderachse der zylindrischen Kurvenwalze 41 und Eingriffspunkt des Verbindungselementes 70 in die Nut bzw. den Kurvensteg aufgespannt (Transportebene = Ebene aus x- und z-Achse). Die Definition der Transportebene ist insbesondere auf die hier gezeigte Ausführungsform anwendbar. Allerdings können andere Ausführungsformen der vorliegenden Erfindung von dieser Definition abweichen, z.B. bei Verwendung eines nicht geradlinig geformten Verbindungselementes 70 (z- oder Stufenform), bei denen der Eingriffspunkt des Verbindungselementes 70 nicht in der Transportebene liegt.

Ferner zeigt Fig. 7 beispielhaft die Einfahr- und Ausfahröffnung einer Kammer 80 (z.B. der Beschichtungskammer). Dabei ist die Öffnung so gewählt, dass das Trägersystem 11 inklusive Verbindungselement 70 gerade noch hindurchpasst. Die Achse der Kurvenwalze 41 und deren Durchmesser bzw. Nuttiefe sind so gewählt, dass die Nut im Bereich der Öffnung der Kammer 80 liegt, um das Verbindungselement 70 (Rolle oder Stift) aufnehmen zu können. Die Achse A der Kurvenwalze 41 inklusive der Antriebswelle und der Drehdurchführung liegen somit außerhalb der Öffnung der Kammer 80. Wie in Fig. 7 gezeigt, können eine Führungsschiene 90 und entsprechende Führungsrollen 91 vorgesehen sein, um das Trägersystem 11 effizient und sicher fortzubewegen.

Mit anderen Worten, wie in Fig. 7 gezeigt ragt ein Teil der Kurvenwalze 41 in Richtung des Vorschubes in die von der Kammer gebildete Öffnung 80. Dieser Teil der Kurvenwalze 41 kann mit dem Verbindungselement 70 in Eingriff gebracht werden, um den Vorschub zu übertragen.

Fig. 7a zeigt eine beispielhafte Anordnung gemäß der vorliegenden Erfindung mit einer Vakuumschleuse 30, drei Kurvenwalzen 40, 41, 42, einem Trägersystem 11 mit zwei Verbindungselementen 70, 71. Die Öffnung der Kammer 80 wird durch die Kammerwand definiert und hat vorzugsweise mindestens eine Kammerinnenwand 82, die an der Position der Vakuumschleuse 30 eine Stufe e1 aufweist, um eine senkrechte Dichtfläche zu erzeugen. Die Dichtfläche zeichnet sich dadurch aus, dass sie eine Dichtung der Öffnung der Kammer 80 und der Vakuumschleuse 30 erlaubt, indem die Vakuumschleuse 30 gegen die durch die Stufe (Aussparung) e1 erzeugte senkrechte Fläche gedrückt wird.

In Fig. 7a ist beispielhaft eine Vakuumschleuse 30 gezeigt, die durch eine Drehbewegung geöffnet und geschlossen werden kann (Drehbewegung ist durch gestrichelte Linie angedeutet). Die Vakuumschleuse ist dabei so platziert, dass diese auch beim Öffnen und Schließen nicht mit der Kurvenwalze kollidiert (siehe gestrichelte Linie). Andere Vakuumschleusen, wie z.B ein linear bewegter Schieber (dessen Störkontur kleiner wäre), sind ebenfalls denkbar.

Wie in Fig. 7a gezeigt, weist die jeweilige Kammer eine Vertiefung 81 auf, in der die jeweilige Kurvenwalze 40, 41, 42 eingebracht ist. Der Achsabstand a (Achse der Kurvenwalze) zur Kammerinnenwand ergibt sich aus der Wanddicke w der Kammer + Radius des Antriebsritzels/Funktionselements r/2 + Spalt s des Funktionselements zur Kammerwand.

Die Kurvenwalze 40, 41, 42 weist dabei einen mittleren Bereich auf, der einen ersten Durchmesser d₁ aufweist und mindestens einen zweiten Durchmesser d₂ an den beiden Enden der Kurvenwalze 40, 41, 42, wobei der zweite Durchmesser d₂ < d₁. Der Durchmesser d₂ kann zu den äußersten Enden der Kurvenwalze weiter verkleinert werden. Die beiden Enden der Kurvenwalze 40, 41, 42 werden außerhalb des Dichtbereichs der Kammer(n) durch ein Funktionselement (z.B. Antriebsritzel, Drehdurchführung) angetrieben. Dazu werden zumindest ein Ende, vorzugsweise beide Enden, der Kurvenwalze 40, 41, 42 aus der durch die Vertiefung gebildeten senkrechten Wände hinausgeführt, um an Atmosphäre durch das Funktionselement (Antriebselement) angetrieben zu werden. Das erfordert eine Tiefe der Vertiefung, die größer ist als die Summe von Achsenabstand a und halbem Durchmesser der Kurvenwalze d₁/2, wobei der Abstand der Kurvenwalzenachse a zur Kammerinnenwand 82 im Bereich d₂/2 < a < d₁/2 liegt.

Kurvenwalzen 40, 41, 42 können sowohl beabstandet zueinander angeordnet sein (wie z.B. Kurvenwalzen 41, 42) oder aber durchgängig an einem Antriebstrang ausgebildet sein (wie z.B. Kurvenwalzen 40, 41), Durch die Verwendung eines kleineren Durchmessers an den Enden der Kurvenwalzen 40, 41, 42 wird in beiden Fällen erreicht, dass eine Vakuumschleuse 30 eingebaut werden kann.

Der Durchmesser d₁ des mittleren Bereichs ist so gewählt, dass die Kurvenwalze 40, 41, 42 über die innere Wand der Kammer hinausragt. Anders formuliert, die Wanddicke der Seite der Öffnung der Kammer 80 auf der die Kurvenwalze 40, 41, 42 angebracht ist, wird so gewählt, dass die Kurvenwalze 40, 41, 42 über die Innenseite dieser Seite der Wand hinausragt, wobei die Kurvenwalze in der Vertiefung 81 eingebracht ist. Vorzugsweise weist die Vertiefung 81 vier im Wesentlichen senkrechte Wandabschnitte mit der Länge (Ausdehnung in x-Richtung, d.h. senkrecht zur Transportrichtung) und einen waagerechten Wandabschnitt, der die vier senkrechten Wandabschnitte verbindet, auf. Der waagerechte Wandabschnitt der Vertiefung hat eine Länge (Ausdehnung in z-Richtung), die größer als die Ausdehnung des mittleren Bereichs der Kurvenwalze in z-Richtung (Transportrichtung) ist. Mit anderen Worten, der Durchmesser der Kurvenwalzen 40, 41, 42 sollte ausreichend groß dimensioniert sein, um eine Antriebswelle außerhalb des Dichtbereiches einer Schleusenklappe (Vakuumschleuse) durch die Kammerwand hindurch an Atmosphäre bringen zu können. Somit kann außerhalb der Kammer (an Atmosphäre) die Drehbewegung eingeleitet werden, z.B. über einen Zahnriemen und Zahnritzel. Ferner sollte der Durchmesser der Kurvenwalzen 40, 41, 42 mindestens um die Länge t in die Kammeröffnung 80 hineinragen, so dass die Verbindungselemente 70, 71 in die Nut der Kurvenwalze eingreifen können. Die Länge g der Verbindungselemente 70, 71 und die Eintauchtiefe d der Verbindungselemente 70, 71 in die Nut der Kurvenwalze sollte der Relation g > d genügen.

Die schraubenförmige Nut ist in dem mittleren Bereich der Kurvenwalze 40, 41, 42 eingebracht. Die Tiefe c der Nut kann in einer beispielhaften Ausführungsform bis mindestens auf die Höhe der inneren Wand der Kammer ausgebildet sein. In dieser Ausführungsform wird die Eintauchtiefe d der Verbindungselemente 70, 71 in die Nut von der Länge g der Verbindungselemente 70, 71 bestimmt, wobei die Länge d < c und d < g. Der Abstand des Verbindungselements zur Achse muss größer als der Achsabstand a sein, so dass das Trägersystem 11 bzw. die Verbindungselemente 70, 71 bei einem Übergang von einer Kammer in die folgende Kammer nicht an der Kammerwand anstoßen, da die Verbindungselemente 70, 71 einen Abstand e > 0 zur Kammerwand aufweisen.

Gemäß den Fig. 1 bis 6 wurden Ausführungsformen beschrieben, bei denen die Trägersysteme 10-12, 60-65 in Transportrichtung in der Transportebene länger als senkrecht zu der Transportrichtung in der Transportebene sind. Mit anderen Worten, die Länge der Trägersysteme 10-12, 60-65 in der Transportrichtung (entlang der z-Achse) übertrifft die Breite der Trägersysteme 10-12, 60-65 (entlang der x-Achse).

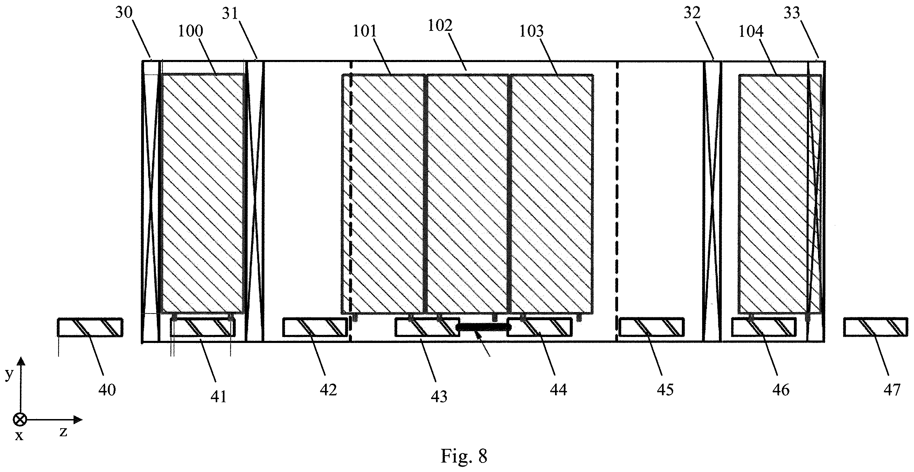

Fig. 8 zeigt nun eine weitere alternative Ausführungsform der vorliegenden Erfindung, wobei die Trägersysteme 100-104 in Transportrichtung in der Transportebene (entlang der z-Achse) kürzer sind als senkrecht zu der Transportebene (entlang der y-Achse) mit einem Längen-Breitenverhältnis von vorzugsweise 0,3-0,5 : 1. Mit anderen Worten, die Breite der Trägersysteme 100-104 (entlang der y-Achse) übertrifft die Länge der Transportsysteme 100-104 (entlang der z-Achse), d.h. die Trägersysteme 100-104 werden mit der langen Seite voran durch die Anlage gefahren. Dadurch kann die Länge des Gesamtsystems, im Vergleich zu den Ausführungsformen der Figuren 1 bis 6, bei gleicher Fördergeschwindigkeit, verringert werden und eine kürzere Durchlaufzeit der Trägersysteme 100-104 erreicht werden. Ferner besteht die Beschichtungskammer (Bearbeitungskammer) gemäß Fig. 8 aus einer Prozesskammer (siehe gestrichelte Linien), die von zwei Pufferkammern eingeschlossen ist. Die Kurvenwalzen 43 und 44 der Prozesskammer sind mechanisch gekoppelt und können mit derselben Geschwindigkeit angesteuert werden. Selbstverständlich könnten die zwei mechanisch gekoppelten Kurvenwalzen 43, 44 auch als eine einzige Kurvenwalze ausgebildet sein. Die anderen Kurvenwalzen 40-42 und 45-47 können durch eine unterschiedliche Ansteuerung die Trägersysteme 100-104 getaktet ein- und ausschleusen. Damit können die Trägersysteme im Bereich zwischen den Vakuumschleusen 31, 32 in der Prozesskammer auf den Kurvenwalzen 43, 44 kontinuierlich bewegt werden und zwischen den Transportsystemen 100-104 kann ein minimaler Spalt realisiert werden.

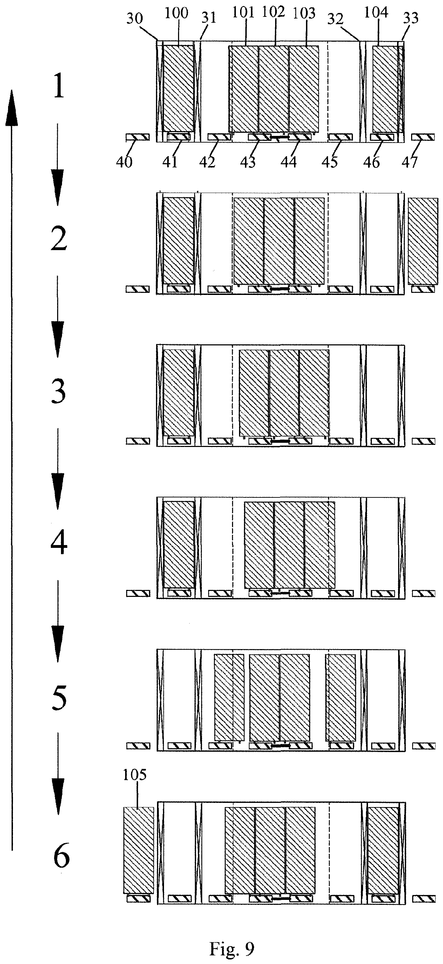

Fig. 9 zeigt einen groben Ablaufplan gemäß der alternativen Ausführungsform von Fig. 8. In einem ersten Schritt befindet sich das Trägersystem 100 bereits in der Einschleusekammer. Die Trägersysteme 101-103 befinden sich in der Beschichtungskammer und ein weiteres Trägersystem 104 fährt gerade aus der Ausschleusekammer zur Entladestation. In einem zweiten Schritt befindet sich das Trägersystem 104 bereits in der Entladestation und die Trägersysteme 101-103 haben sich mit konstanter Geschwindigkeit weiter in der Beschichtungskammer fortbewegt. In einem dritten Schritt befindet sich das Trägersystem 104 bereits weiter auf dem Anlagentransportsystem (nicht gezeigt) und die Trägersysteme 101-103 haben sich in der Beschichtungskammer weiter fortbewegt. In einem vierten Schritt haben sich die Trägersysteme 101-103 mit einer konstanten Geschwindigkeit fortbewegt. In einem fünften Schritt schließt nun das Trägersystem 100 vorausfahrende Trägersystem 101 auf. In einem sechsten Schritt befindet sich das Trägersystem 103 bereits in der Ausschleusekammer, die Trägersysteme 100-102 befinden sich in der Beschichtungskammer und ein neues Trägersystem 105 befindet sich in der Beladestation.

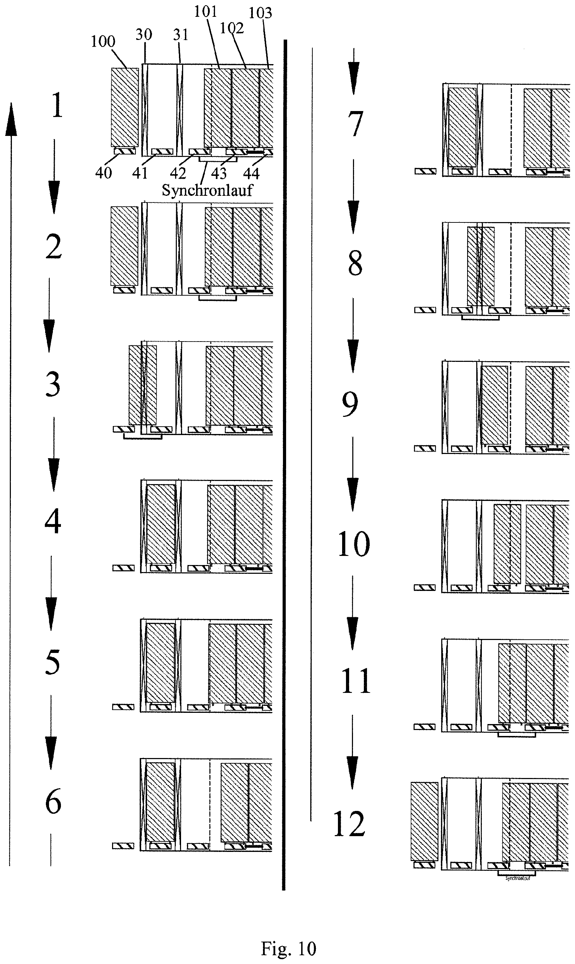

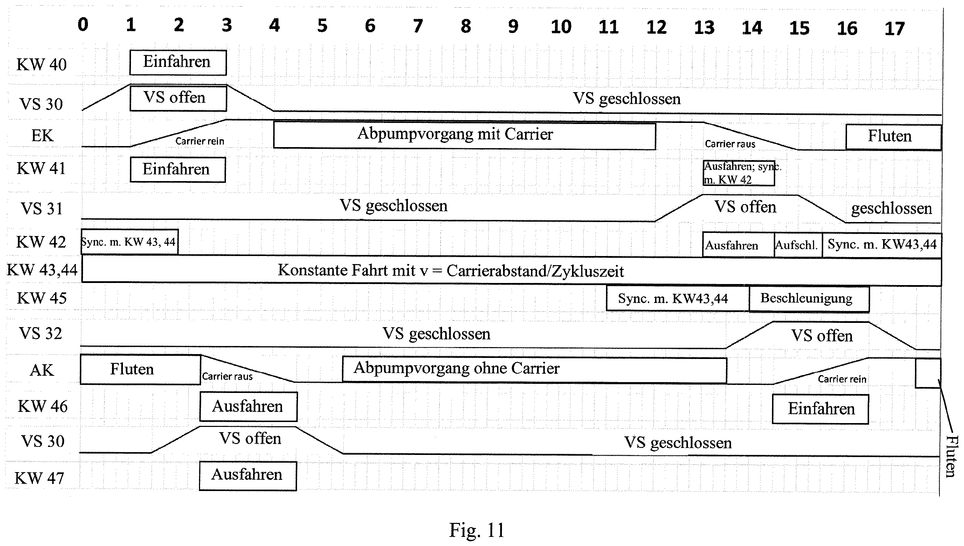

Der oben beschriebene grobe Ablaufplan ermöglicht somit eine konstante Geschwindigkeit der Trägersysteme auf den Kurvenwalzen 43, 44 (konstante Fahrt mit v = Carrierabstand/Zykluszeit, z.B. 600mm/18s = 2m/min). Durch die individuelle Ansteuerung der übrigen Kurvenwalzen 40-42, 45-47 besteht somit die Möglichkeit, dass die vorderen Trägersysteme, z.B. Trägersystem 103 im fünften Schritt, sich mit einer höheren Geschwindigkeit von den hinteren Trägersystemen löst bevor das Trägersystem 103 dann in die Ausschleusekammer fährt. Gleichzeitig ermöglicht die selektive Ansteuerung der übrigen Kurvenwalzen 40-42, 45-47, dass ein hinteres Trägersystem, z.B. Trägersystem 100 im fünften Schritt, durch eine höhere Geschwindigkeit auf die vorderen Trägersysteme 101, 102 aufschließen kann. Dies wird noch deutlicher durch die Figuren 10 und 11.

Fig. 10 zeigt einen detaillierteren Ablaufplan, wobei lediglich der vordere Teil des Gesamtsystems aus Fig. 9 gezeigt ist. Im Ausgangszustand (Schritt 1) befindet sich ein Trägersystem 100 in der Beladestation, der Antrieb (Kurvenwalze 40) steht still. Die Vakuumschleusen 30, 31 sind geschlossen und die Einschleusekammer ist leer. Der Flutvorgang der Einschleusekammer wurde gerade beendet und der Antrieb der Kurvenwalze 41 steht still. In der Beschichtungskammer hat die Zugbildung stattgefunden, die Kurvenwalzen 42-44 fahren synchron mit der eingestellten Prozessgeschwindigkeit. Im zweiten Schritt wird die Vakuumschleuse 30 geöffnet.

Im dritten Schritt fährt das Trägersystem 100 von der Beladestation in die Einschleusekammer. Die Kurvenwalzen 40, 41 fahren synchron mit hoher Transportgeschwindigkeit. In der Beschichtungskammer hat das letzte Trägersystem 101 (bzw. die letzte Laufrolle des Trägersystems 101) die Kurvenwalze 42 der Pufferkammer verlassen. In einem vierten Schritt ist das Trägersystem 100 in die Einschleusekammer eingefahren und der Antrieb der Kurvenwalze 42 wird angehalten. Der Antrieb der Kurvenwalze 40 in der Beladestation steht bereit ein neues Trägersystem aufzunehmen. In einem fünften Schritt wird die Vakuumschleuse 30 geschlossen. In einem sechsten Schritt wird die Einschleusekammer evakuiert.

In einem siebten Schritt wird die Vakuumschleuse 31 geöffnet. In einem achten Schritt fahren die Kurvenwalzen 41, 42 synchron mit schneller Transportgeschwindigkeit. In einem neunten Schritt hat die letzte Laufrolle des Trägersystems 100 die Kurvenwalze 41 verlassen. Der Antrieb der Kurvenwalze 41 wird daraufhin abgebremst, der Antrieb der Kurvenwalze 42 der Pufferkammer wird so angesteuert, dass das Trägersystem 100 zu dem Trägersystem 101 in der Beschichtungskammer aufschließt. In einem zehnten Schritt wird die Vakuumschleuse 31 geschlossen.

In einem elften Schritt ist die Vakuumschleuse 31 dann bereits geschlossen und die Einschleusekammer kann geflutet werden. Das Trägersystem 100 hat mittlerweile zu dem Trägersystem 101 aufgeschlossen Der Antrieb der Kurvenwalzen 42 fährt synchron zum Antrieb der Kurvenwalze 43. Der zwölfte Schritt ist identisch mit dem im ersten Schritt dargestellten Zustand, d.h. die Einschleusekammer ist geflutet und in der Beladestation steht ein neues Trägersystem 105 bereit. Das Auseinanderfahren und das Ausschleusen der Trägersysteme sind analog zu dem oben beschriebenen Verfahren und kann dem Schema aus Fig. 11 entnommen werden.

Fig. 11 zeigt ein Ablaufschema für die einzelnen Vakuumschleusen (VS) 30-33 (vgl. Fig. 9), die Kurvenwalzen (KW) 40-47 sowie den Zustand der Einschleusekammer (EK) und der Ausschleusekammer (AK). Wie aus Fig. 11 hervorgeht ist es gemäß dieser alternativen Ausführungsform vorteilhaft möglich, die Kurvenwalzen 43, 44 mit einer konstanten Geschwindigkeit in der Beschichtungskammer zu bewegen.

Die vorhergehend beschriebenen beispielhaften Ausführungsformen können sowohl für Trägersysteme in horizontaler Ausrichtung als auch für Trägersysteme in vertikaler Ausrichtung äquivalent ausgeführt sein. Wie bereits beschrieben können die Anlagen nach der Orientierung der Trägersysteme (Carrier) unterschieden werden (horizontal und vertikale Anlagen).

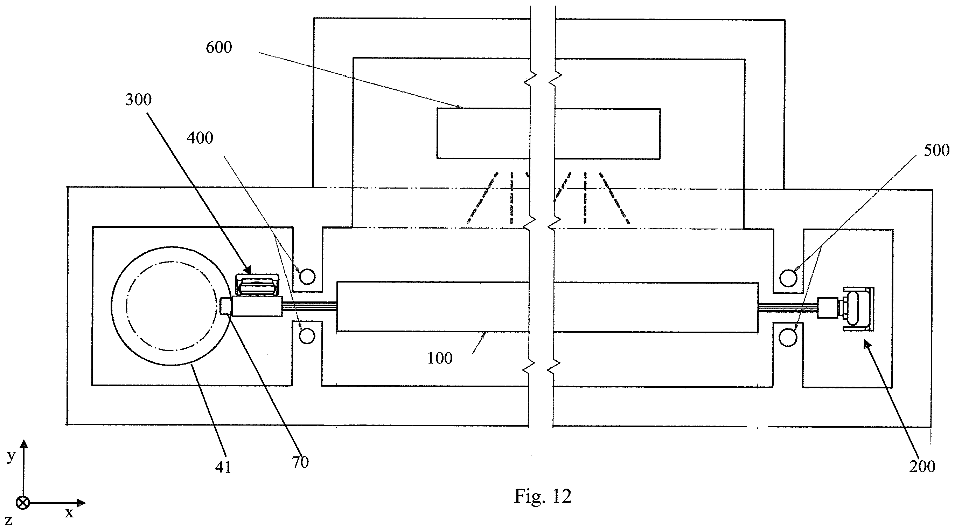

Gemäß Fig. 12 ist ein formschlüssiger Antrieb ähnlich zu dem in Fig. 7 gezeigtem Antrieb dargestellt. Der Aufbau gemäß Fig. 12 ist ein Beispiel für eine horizontale Ausrichtung des Trägersystems 100.

Zusätzlich zu dem in Fig. 7 dargestellten Antrieb, weist die Ausführungsform gemäß Fig. 12 Führungselemente 200, 300 auf. Ferner ist eine Kühlung 400, 500 an den entsprechenden Enden des Trägersystems 100 sowie eine Beschichtungsquelle 600 gezeigt. Da das erfindungsgemäße Antriebssystem schlupffrei ist und somit große Antriebskräfte übertragen kann, kann hier ein reibungsbehaftetes Führungssystem für die Trägersysteme 10-12, 60-65, 100-105 eingesetzt werden, welches einen präzisen Geradeauslauf gewährleistet und ein Verkannten der Trägersysteme 10-12, 60-65, 100-105 vermeidet.

Auf der Antriebsseite (auf der Seite der Kurvenwalze 41) ist erfindungsgemäß ein erstes Führungselement 300 in einem "Festlager" realisiert, welches Kräfte in zwei Richtungen senkrecht zur Transportebene und Rotationsmomente in drei Richtungen aufnehmen kann. Das erste Führungselement 300 kann sich somit nur in Transportrichtung bewegen. Am gegenüberliegenden Ende befindet sich ein als "Loslager" ausgebildetes zweites Führungselement 200, welches zur Abstützung von Kippkräften dient und eine thermische Ausdehnung des Trägersystems 100 erlaubt. Die Führungselemente sind bei der horizontalen Variante sowohl zur Transportebene als auch Transportrichtung parallel angebracht.

Die Transportrichtung (z-Richtung) erstreckt sich auch in dieser Ausführungsform entlang der Zylinderachse der zylindrischen Kurvenwalze 41. Die Transportebene wird durch die Transportrichtung (z-Achse) und dem Radius der Kurvenwalze 41 zum Eingriffspunkt des Verbindungselementes 70 in die Nut oder den Kurvensteg (x-Achse) eindeutig festgelegt. Die Transportebene kann in der horizontalen Ausrichtung alternativ auch als Ebene definiert werden, die durch die Transportrichtung (z-Richtung) und der Verbindung zwischen dem Mittelpunkt der Kurvenwalze 41 und dem zweiten Führungselement 200 festgelegt wird. Wie bereits erwähnt ist diese Definition der Transportebene insbesondere auf die hier gezeigte Ausführungsform anwendbar. Allerdings können andere Ausführungsformen der vorliegenden Erfindung von dieser Definition abweichen, z.B. bei Verwendung eines nicht geradlinig geformten Verbindungselementes 70 (gekröpfte oder abgewinkelte Verbindungselemente), bei denen der Eingriffspunkt des Verbindungselementes 70 nicht in der Transportebene liegt.

Das zusätzliche Führungssystem, bestehend aus den Führungselementen 200, 300, ist besonders vorteilhaft bei den Ausführungsformen der Fig. 9 bis 11, bei denen die Trägersysteme 100-105 breiter als lang sind, d.h. mit der langen Seite voran durch die Durchlaufanlage gefördert werden.

Bei nahezu allen anderen bekannten Antriebssystemen liegen die Trägersysteme durch Eigengewicht auf den Antriebsrollen auf (wie bereits oben beschrieben). Ein separates Führungssystem kann deshalb in solchen Systemen nicht eingesetzt werden, weil die Reibung dieses Führungssystems veränderlich ist und somit der durch Reibung erzeugte Vorschub von der Reibung des Führungssystems verändert würde. Durch die Verwendung der Führungselemente 200, 300 gemäß Fig. 12, ist es erfindungsgemäß vorteilhaft möglich, Trägersysteme mit einem Längen/Breiten-Verhältnis von vorzugsweise 0,3-0,5 : 1 zu verwenden, wodurch die Anlage deutlich kürzer ausgeführt werden kann.

Selbstverständlich können die Führungselemente 200, 300 ebenfalls für Trägersysteme in vertikaler Ausrichtung verwendet werden. Bei Trägersystemen in vertikaler Ausrichtung ist die Höhe (entlang der y-Achse) im Verhältnis zur Länge (entlang der z-Achse) und/oder Breite (entlang der x-Achse) größer. Dadurch entstehen ähnliche Probleme, wie bei dem oben beschriebenen unterschiedlichen Längen/Breiten-Verhältnis. Bei der vertikalen Ausrichtung ist das Führungselement 200 dann an der Unterseite des Trägersystems und das Führungselement 300 an der Oberseite des Trägersystems angebracht, d.h. die Führungselemente 200, 300 sind in diesem Fall entlang der y-Achse angebracht.

Die oben beschriebenen beispielhaften Ausführungsformen der vorliegenden Erfindung können dabei für verschiedene Prozesse in verschiedenen Transportanlagen angewandt werden. Dabei wird das Verfahren den verschiedenen Bedingungen der verschiedenen Prozesse in den Transportanlagen angepasst ohne von der vorliegenden Erfindung abzuweichen. Es könnte z.B. eine mechanische Verbindung zwischen den Kurvenwalzen 40, 41, 43, 44 hergestellt werden, wodurch diese nur einen Motor zum Antrieb verwenden könnten.

Während die vorliegende Erfindung hier unter Bezug auf ihre bevorzugten Ausführungsformen beschrieben und dargestellt wurde, ist für Fachleute auf dem Gebiet offensichtlich, dass verschiedene Modifikationen und Änderungen daran vorgenommen werden können, ohne den Schutzbereich der Erfindung zu verlassen. Auf diese Weise ist beabsichtigt, dass die vorliegende Erfindung die Modifikationen und Änderungen dieser Erfindung abdeckt, sofern sie in den Schutzbereich der beigefügten Patentansprüche und ihrer Äquivalente fallen.

## Patentansprüche

1. Durchlaufanlage mit:
mindestens einem Trägersystem (10-12, 60-65, 100-105) mit mindestens zwei Verbindungselementen (70);
mehreren in Transportrichtung (z-Richtung) in einer Transportebene (x-z-Ebene) hintereinander angeordneten Transportsystemen, wobei die Transportsysteme jeweils eine zur Transportrichtung achsparallele Kurvenwalze (40-47) aufweist, wobei die Kurvenwalzen (40-47) einen mittleren Bereich aufweisen, der einen ersten Durchmesser d₁ aufweist und mindestens einen zweiten Durchmesser d₂ an den Enden der Kurvenwalzen (40-47), wobei d₂ < d₁, wobei der Abstand zwischen zwei aufeinander folgende mittlere Bereiche der Kurvenwalzen (40-47) kleiner als der Abstand zwischen den mindestens zwei Verbindungselementen (70) eines Trägersystems (10-12, 60-65, 100-105) ist, wobei die Kurvenwalzen (40-47) in dem mittleren Bereich eine schraubenförmige Nut oder einen schraubenförmigen Kurvensteg aufweisen und die Verbindungselemente (70) des Trägersystems (10-12, 60-65, 100-105) formschlüssig in die Nut der Kurvenwalze (40-47) eingreifen bzw. den Kurvensteg umgreifen, wobei die Transportsysteme mindestens eine Bearbeitungskammer mit mindestens zwei Vakuumschleusen (30-33) für einen Vakuumbetrieb der Bearbeitungskammer aufweisen, wobei die Bearbeitungskammer eine Kammerinnenwand (82) aufweist, wobei die Bearbeitungskammer eine Vertiefung (81) aufweist in der die Kurvenwalze (40-47) angeordnet ist, wobei ein Abstand a der Kurvenwalzenachse zur Kammerinnenwand (82) im Bereich d₂/2 < a < d₁/2 liegt; und
mindestens eine Antriebseinheit (20-24) zum Antrieb der Kurvenwalzen (40-47).

2. Durchlaufanlage nach Anspruch 1, wobei das Verbindungselement (70) mindestens eine oder mehrere drehbar gelagerte Laufrollen aufweist.

3. Durchlaufanlage nach Anspruch 1, wobei das Verbindungselement (70) ein stiftförmiges Element aufweist.

4. Durchlaufanlage nach einem der Ansprüche 1 bis 3, wobei die Transportsysteme eine Be- und Entladekammer aufweisen.

5. Durchlaufanlage nach einem der Ansprüche 1 bis 4, wobei die Transportsysteme eine Ein- und Ausschleusekammer aufweisen.

6. Durchlaufanlage nach Anspruch 5, wobei die Ein- und Ausschleusekammer mindestens zwei Vakuumschleusen (30-33) für einen Vakuumbetrieb der Kammern aufweisen.

7. Durchlaufanlage nach einem der Ansprüche 1 bis 6, wobei jedes der mehreren Transportsysteme eine eigene Antriebseinheit (20-24) aufweist.

8. Durchlaufanlage nach einem der Ansprüche 1 bis 7, wobei die Antriebseinheiten (20-24) oder Kurvenwalzen (40-47) jeweils einen Encoder zur Positionsbestimmung der Trägersysteme aufweisen.

9. Durchlaufanlage nach einem der Ansprüche 1 bis 8, wobei das mindestens eine Trägersystem (10-12, 60-65) in der Transportrichtung länger als senkrecht zu der Transportrichtung in der Transportebene und länger als senkrecht zu der Transportebene ist.

10. Durchlaufanlage nach einem der Ansprüche 1 bis 8, wobei das mindestens eine Trägersystem (100-105) in der Transportrichtung in der Transportebene kürzer als senkrecht zu der Transportrichtung in der Transportebene und/oder kürzer als senkrecht zu der Transportebene ist, vorzugsweise im Verhältnis 0,3-0,5:1.

11. Durchlaufanlage nach Anspruch 10, mit einem reibungsbehafteten Führungssystem (200, 300), das vorzugsweise ein erstes Führungselement (300) und ein zweites Führungselement (200) aufweist, wobei das erste Führungselement (300) auf der Seite des Trägersystems (100-105) mit dem Verbindungselement (70) angeordnet ist und das zweite Führungselement (200) auf der gegenüberliegenden Seite des Trägersystems (100-105) angeordnet ist.

12. Durchlaufanlage nach einem der Ansprüche 1 bis 11, wobei die Bearbeitungskammer mindestens eine erste Pufferkammern, mindestens eine Prozesskammer im Anschluss an die mindestens eine erste Pufferkammer und mindestens eine zweite Pufferkammer im Anschluss an die mindestens eine Prozesskammer aufweist.

13. Durchlaufanlage nach einem der Ansprüche 1 bis 12, mit einer Einrichtung zur individuellen Ansteuerung der mehreren Transportsysteme zum kontinuierlichen Lauf der Trägersysteme (10-12, 60-65, 100-105) in der Bearbeitungskammer und/oder zum Einstellen eines vorgegebenen Abstands zwischen den hintereinander angeordneten Trägersystemen (10-12, 60-65, 100-105).

14. Durchlaufanlage nach einem der Ansprüche 1 bis 13, wobei mindestens ein Enden der Kurvenwalzen (40-47) mit dem Durchmesser d₂ durch mindestens eine Wand der Vertiefung (81) nach außen geführt wird, um dort durch die Antriebseinheit (20-24) angetrieben zu werden.

15. Durchlaufanlage nach einem der Ansprüche 1 bis 14, wobei der Abstand a der Kurvenwalzenachse zur Kammerinnenwand gleich der Summe aus einer Kammerwanddicke w, des Radius des Antriebsritzels/Funktionselements r/2 und eines Spalts des Funktionselements zur Kammerwand s ist.

## Claims

1. A continuous system comprising:
at least one carrier system (10-12, 60-65, 100-105) comprising at least two connecting elements (70);
several transport systems arranged one after the other in the transport direction (z-direction) within a transport plane (x-z-plane), wherein the transport systems each have a cylindrical cam (40-47) being axially parallel with respect to the transport direction, wherein the cylindrical cams (40-47) have a central region having a first diameter d₁ and at least a second diameter d₂ at the ends of the cylindrical cams (40-47), wherein d₂ < d₁, wherein the distance between two successive central regions of the cylindrical cams (40-47) is smaller than the distance between the at least two connecting elements (70) of a carrier system (10-12, 60-65, 100-105), wherein in the central region, the cylindrical cams (40-47) have a helical groove or a helically curved web, and the connecting elements (70) of the carrier system (10-12, 60-65, 100-105) engage interlockingly with the groove of the cylindrical cam (40-47) or encompass the curved web, wherein the transport systems comprise at least one processing chamber with at least two vacuum locks (30-33) for a vacuum operation of the processing chamber, wherein the processing chamber comprises an inner chamber wall (82), wherein the processing chamber comprises a recess (81) in which the cylindrical cam (40-47) is arranged, wherein a distance a of the cylindrical cam axis relative to the inner chamber wall (82) lies in the range of d₂/2 < a < d₁/2, and
at least one drive unit (20-24) for driving the cylindrical cams (40-47).

2. The continuous system according to claim 1, wherein the connecting element (70) comprises at least one or more runners which are supported so as to be rotatable.

3. The continuous system according to claim 1, wherein the connecting element (70) comprises a pin-shaped element.

4. The continuous system according to any one of claims 1 to 3, wherein the transport systems comprise a loading and unloading chamber.

5. The continuous system according to any one of claims 1 to 4, wherein the transport systems comprise a charging and discharging chamber.

6. The continuous system according to claim 5, wherein the charging and discharging chamber comprises at least two vacuum locks (30-33) for a vacuum operation of the chambers.

7. The continuous system according to any one of claims 1 to 6, wherein each of the several transport systems comprises its own drive unit (20-24).

8. The continuous system according to any one of claims 1 to 7, wherein the drive units (20-24) or cylindrical cams (40-47) each have an encoder for determining the position of the carrier systems.

9. The continuous system according to any one of claims 1 to 8, wherein the at least one carrier system (10-12, 60-65) is longer in the transport direction than perpendicularly to the transport direction within the transport plane and longer than perpendicularly to the transport plane.

10. The continuous system according to any one of claims 1 to 8, wherein the at least one carrier system (100-105) is shorter in the transport direction within the transport plane than perpendicularly to the transport direction within the transport plane and/or shorter than perpendicularly to the transport plane, preferably at a ratio of 0.3-0.5 : 1.

11. The continuous system according to claim 10, comprising a friction-involving guide system (200, 300) which preferably comprises a first guide element (300) and a second guide element (200), wherein the first guide element (300) is arranged at the side of the carrier system (100-105) with the connecting element (70) and the second guide element (200) is arranged at the opposite side of the carrier system (100-105).

12. The continuous system according to any one of claims 1 to 11, wherein the processing chamber comprises at least one first buffer chamber, at least one process chamber following the at least one first buffer chamber and at least one second buffer chamber following the at least one process chamber.

13. The continuous system according to any one of claims 1 to 12, comprising means for individually controlling the several transport systems for a continuous running of the carrier systems (10-12, 60-65, 100-105) in the processing chamber and/or for adjusting a predetermined distance between the successively arranged carrier systems (10-12, 60-65, 100-105).

14. The continuous system according to any one of claims 1 to 13, wherein at least one end of the cylindrical cams (40-47) with the diameter d₂ is led outwardly through at least one wall of the recess (81) in order to be driven there by the drive unit (20-24).

15. The continuous system according to any one of claims 1 to 14, wherein the distance a of the cylindrical cam axis relative to the inner wall of the chamber is equal to the sum of a chamber wall thickness w, the radius of the drive pinion/functional element r/2 and a gap between the functional element and the chamber wall s.

## Revendications

1. Installation de traitement en continu, avec :
au moins un système porteur (10-12, 60-65, 100-105) comprenant au moins deux éléments de connexion (70) ;
plusieurs systèmes de transport disposés successivement sur un plan de transport (plan x-z) dans la direction de transport (direction z), lesdits systèmes de transport comportant chacun un cylindre à cames (40-47) axialement parallèle à la direction de transport, les cylindres à cames (40-47) présentant une partie centrale ayant un premier diamètre d₁ et au moins un deuxième diamètre d₂ aux extrémités des cylindres à cames (40-47), d₂ étant inférieur à d₁, la distance entre deux parties centrales successives des cylindres à cames (40-47) étant inférieure à la distance entre les au moins deux éléments de connexion (70) d'un système porteur (10-12, 60-65, 100-105), les cylindres à cames (40-47) présentant une rainure hélicoïdale ou une nervure de came hélicoïdale dans la partie centrale et les éléments de connexion (70) du système porteur (10-12, 60-65, 100-105) s'engageant positivement dans la rainure du cylindre à cames (40-47) ou enserrant la nervure de came, les systèmes de transport comprenant au moins une chambre de traitement avec au moins deux sas à vide (30-33) pour un fonctionnement à vide de la chambre de traitement, la chambre de traitement présentant une paroi intérieure de chambre (82), la chambre de traitement présentant un renfoncement (81) où est disposé le cylindre à cames (40-47), une distance a entre l'axe de cylindre à cames et la paroi intérieure de chambre (82) satisfaisant à d₂/2 < a < d₁/2 ; et
au moins une unité d'entraînement (20-24) pour l'entraînement des cylindres à cames (40-47).

2. Installation de traitement en continu selon la revendication 1, où l'élément de connexion (70) comprend au moins un ou plusieurs roulements montés de manière rotative.

3. Installation de traitement en continu selon la revendication 1, où l'élément de connexion (70) comprend un élément en forme de tige.

4. Installation de traitement en continu selon l'une des revendications 1 à 3, où les systèmes de transport comprennent une chambre de chargement et de déchargement.

5. Installation de traitement en continu selon l'une des revendications 1 à 4, où les systèmes de transport comprennent une chambre d'introduction et d'extraction.

6. Installation de traitement en continu selon la revendication 5, où la chambre d'introduction et d'extraction comprend au moins deux sas à vide (30-33) pour un fonctionnement à vide des chambres.

7. Installation de traitement en continu selon l'une des revendications 1 à 6, où chacun des plusieurs systèmes de transport a une unité d'entraînement (20-24) propre.

8. Installation de traitement en continu selon l'une des revendications 1 à 7, où les unités d'entraînement (20-24) ou les cylindres à cames (40-47) sont dotés chacun d'un codeur pour la détermination de position des systèmes porteurs.

9. Installation de traitement en continu selon l'une des revendications 1 à 8, où ledit au moins un système porteur (10-12, 60-65) est dans la direction de transport plus long que perpendiculairement à la direction de transport dans le plan de transport et plus long que perpendiculairement au plan de transport.

10. Installation de traitement en continu selon l'une des revendications 1 à 8, où ledit au moins un système porteur (100-105) est dans la direction de transport dans le plan de transport plus court que perpendiculairement à la direction de transport dans le plan de transport et/ou plus court que perpendiculairement au plan de transport, préférentiellement suivant un rapport 0,3-0,5:1.

11. Installation de traitement en continu selon la revendication 10, avec un système de guidage (200, 300) à friction, comprenant préférentiellement un premier élément de guidage (300) et un deuxième élément de guidage (200), le premier élément de guidage (300) étant situé sur le côté du système porteur (100-105) avec l'élément de connexion (70) et le deuxième élément de guidage (200) étant situé sur le côté opposé du système porteur (100-105).

12. Installation de traitement en continu selon l'une des revendications 1 à 11, où la chambre de traitement comprend au moins une première chambre tampon, au moins une chambre de processus adjacente à ladite au moins une première chambre tampon et au moins une deuxième chambre tampon adjacente à ladite au moins une chambre de processus.

13. Installation de traitement en continu selon l'une des revendications 1 à 12, avec un dispositif pour la commande individuelle des plusieurs systèmes de transport pour la marche continue des systèmes porteurs (10-12, 60-65, 100-105) dans la chambre de traitement et/ou pour le réglage d'un intervalle prescrit entre les systèmes porteurs (10-12, 60-65, 100-105) successifs.

14. Installation de traitement en continu selon l'une des revendications 1 à 13, où au moins une extrémité des cylindres à cames (40-47) ayant le diamètre d₂ est passée vers l'extérieur par au moins une paroi du renfoncement (81) pour y être entraînée par l'unité d'entraînement (20-24).

15. Installation de traitement en continu selon l'une des revendications 1 à 14, où la distance a entre l'axe de cylindre à cames et la paroi intérieure de chambre est égale à la somme d'une épaisseur de paroi de chambre w, du rayon du pignon d'entraînement/élément fonctionnel r/2 et d'un interstice s entre l'élément fonctionnel et la paroi de chambre.
